# EUROPEAN PATENT APPLICATION

(11) **EP 4 131 335 A1**
(43) Date of publication of application: **08.02.2023**
(21) Application number: 21775084.3
(22) Date of filing: 08.03.2021
(51) Int. Cl.: H01L 21/02

(54) **METHOD FOR MANUFACTURING BONDED WAFER AND BONDED WAFER**

(30) Priority: 25.03.2020 JP 2020054968
(71) Applicant: Shin-Etsu Handotai Co., Ltd., Tokyo 100-0004 (JP)
(72) Inventor: ISHIZAKI, Junya, Annaka-shi, Gunma 379-0196 (JP); FURUYA, Shogo, Annaka-shi, Gunma 379-0196 (JP)
(74) Representative: Sonnenhauser, Thomas Martin
(86) International application number: PCT/JP2021/008849
(87) International publication number: WO 2021/192938

(57) **Abstract**

The present invention is a method for manufacturing a bonded wafer, the method including bonding a to-be-bonded wafer and a compound semiconductor wafer including a compound semiconductor epitaxially grown on a growth substrate. An area of a bonding surface of the to-be-bonded wafer is larger than an area of a bonding surface of the compound semiconductor wafer. The growth substrate is removed after the to-be-bonded wafer is bonded to the compound semiconductor wafer. This provides a method for manufacturing a bonded wafer with suppressed crack formation.

## Description

### TECHNICAL FIELD

The present invention relates to a method for manufacturing a bonded wafer, and a bonded wafer.

### BACKGROUND ART

Epitaxial wafers (EPWs) for various compound semiconductor devices have been manufactured by using GaAs substrates and InP substrates. The maximum diameters of GaAs substrates are 6 inches (150 mm), and InP substrates are 4 inches (100 mm) substrates.

After an EPW is prepared, it is necessary to perform a process in which an electrode is formed to manufacture a device. Nevertheless, at present, the mainstream manufacturing apparatuses are for diameters of 8 inches (200 mm) or more, and it is difficult to obtain a new apparatus for diameters of 6 inches or less. For this reason, various methods are proposed for a process of manufacturing devices from small-diameter wafers by using an apparatus for large diameters.

In one of the methods, a groove designed for small diameter is cut in a wafer with large diameter to prepare a template, and a compound semiconductor wafer is placed thereon and subjected to the subsequent process. This method can be performed easily at low cost, but has a problem that the template and the wafer are not physically in close contact.

Meanwhile, a photolithography process requires a step of heating a wafer with a hot plate before and after exposing a resist to light. However, if the attachment to the template is weak, this brings about a problem that the thermal resistance between the template and the wafer is increased, making the photolithography conditions unstable.

To solve the above problems, it is necessary to bring a template wafer and an EPW into close contact. Patent Document 1 discloses a method in which a template wafer and an EPW are bonded using a polyimide material for tentative immobilization, and then processed.

This method is an excellent method in terms of attachment to the template. However, after the device manufacturing step, the delamination from the template is necessary. In principle, a residue remains on the delaminated surface, so that the removal step needs to be performed. Since the polyimide cannot be sufficiently removed by heat dissociation or organic solvent, oxygen plasma ashing needs to be performed. This results in a problem that the surface of the compound wafer is oxidized in the removal step.

In addition, compound EPWs have hetero-epitaxial structures. In the hetero-epitaxy, the growth is carried out such that lattice constants are made substantially the same by adjusting the growth temperature. When the temperature is lowered to room temperature, warp is caused due to difference in coefficient of thermal expansion. In other words, at room temperature, internal stress is generated in the compound semiconductor epitaxial layer. This internal stress continuously changes with temperatures.

The higher the temperature in bonding, the larger the difference in internal stresses when the temperature is lowered to room temperature. If a to-be-bonded wafer serving as a template and an EPW are made of different materials, stress due to difference in coefficient of thermal expansion is applied to the compound semiconductor wafer in principle.

In a case where a to-be-bonded member has a smaller coefficient of thermal expansion than an EPW substrate, when the temperature is lowered from that at the time of bonding to room temperature, tensile stress is applied to the EPW substrate. The larger the tensile stress, the more likely it is that the substrate is cracked.

If a template substrate is made of silicon, the coefficient of thermal expansion is lower than that of a compound semiconductor. Hence, the compound semiconductor EPW bonded by heating receives tensile stress after the temperature is lowered to room temperature.

In the case of bonding to a wafer having a different diameter, if the bonding is performed at a temperature of 200°C or higher, many cracks are generally formed in a compound semiconductor, and the compound semiconductor EPW is broken. This is a problem caused by internal stress due to difference in coefficient of thermal expansion. This problem cannot be solved solely by ordinary bonding.

### CITATION LIST

### PATENT LITERATURE

Patent Document 1: 6213977 B2

### SUMMARY OF INVENTION

### TECHNICAL PROBLEM

The present invention has been made in view of the above-described problems. An object of the present invention is to provide a method for manufacturing a bonded wafer by which crack formation in an epitaxial layer is suppressed when a substrate allowing device processing is prepared by bonding the compound semiconductor epitaxial wafer with small diameter or small size onto a to-be-bonded wafer.

### SOLUTION TO PROBLEM

To achieve the object, the present invention provides a method for manufacturing a bonded wafer, the method comprising bonding a to-be-bonded wafer and a compound semiconductor wafer that includes a compound semiconductor epitaxially grown on a growth substrate, wherein
an area of a bonding surface of the to-be-bonded wafer is larger than an area of a bonding surface of the compound semiconductor wafer, and
the growth substrate is removed after the to-be-bonded wafer is bonded to a side, where the compound semiconductor is epitaxially grown, as the bonding surface of the compound semiconductor wafer.

According to such a method for manufacturing a bonded wafer, when a substrate allowing device processing is prepared by bonding a compound semiconductor wafer with small diameter or small size onto a to-be-bonded wafer, a growth substrate is removed after the bonding, so that the epitaxial layer in the resulting bonded wafer has less crack formation.

In this event, the bonding of the to-be-bonded wafer and the compound semiconductor wafer is preferably performed by any method of direct bonding with no interposition therebetween, metal bonding with a metal, and bonding with a resin or polymer interposed therebetween.

Such bonding methods can facilitate the bonding to some extent, and the bonded product can be directly utilized as a final device element.

In this event, the metal preferably comprises at least one or more of Au, Ag, Al, In, and Ga. Additionally, the resin or polymer preferably comprises benzocyclobutene, polyimide, or glass with TEOS.

These can suppress bonding failure incidences at the time of bonding.

In this event, the bonding is preferably performed such that a center of the compound semiconductor wafer and a center of the to-be-bonded wafer are arranged to deviate from each other by 5 mm or less.

In this way, crack formation can be further suppressed.

The compound semiconductor wafer from which the growth substrate has been removed may have a total thickness of 15 um or less.

In this way, crack formation can be suppressed more reliably.

The to-be-bonded wafer comprises silicon, sapphire, or quartz preferably.

In this way, a bonded wafer can be prepared at low cost.

Moreover, the present invention provides a bonded wafer comprising:
a compound semiconductor wafer; and
a to-be-bonded wafer bonded thereto and having an area larger than an area of a bonding surface of the compound semiconductor wafer, wherein
the compound semiconductor wafer has a total thickness of 15 µm or less.

According to such a bonded wafer, the epitaxial layer in the bonded wafer has less crack formation.

### ADVANTAGEOUS EFFECTS OF INVENTION

As described above, the inventive method for manufacturing a bonded wafer makes it possible to manufacture a bonded wafer in a thin film form whose epitaxial layer has crack formation suppressed by removing a growth substrate after the compound semiconductor epitaxial wafer with small diameter or small size is bonded onto a to-be-bonded wafer when a substrate allowing device processing is prepared. Moreover, the inventive bonded wafer has an epitaxial layer with successfully suppressed crack formation.

### BRIEF DESCRIPTION OF DRAWINGS

FIG. 1 is a view illustrating an example of a schematic cross-sectional view of a compound semiconductor wafer (EPW) usable in a method for manufacturing a bonded wafer according to the present invention (first embodiment).
FIG. 2 is a view illustrating an example of the compound semiconductor wafer (EPW) and a to-be-bonded wafer in the first embodiment.
FIG. 3 is a view illustrating an example of bonding the compound semiconductor wafer (EPW) to the to-be-bonded wafer in the first embodiment.
FIG. 4 is a view illustrating the compound semiconductor wafer (EPW) in a circular form and a central point thereof (black circle) in the first embodiment.
FIG. 5 is a view illustrating the to-be-bonded wafer in a circular form and a central point thereof (black circle) in the first embodiment.
FIG. 6 is a view illustrating the compound semiconductor wafer (EPW) in a rectangular form and a central point thereof (black circle) in the first embodiment.
FIG. 7 is a view illustrating an example of removing a growth substrate after the compound semiconductor wafer (EPW) is bonded to the to-be-bonded wafer in the first embodiment.
FIG. 8 is a view illustrating an example of covering with a silicon wafer after the compound semiconductor wafer (EPW) is bonded to the to-be-bonded wafer and then the growth substrate is removed in the first embodiment.
FIG. 9 is a view illustrating an example of a schematic cross-sectional view of a compound semiconductor wafer (EPW) usable in a method for manufacturing a bonded wafer according to the present invention (second embodiment).
FIG. 10 is a view illustrating an example of vapor-depositing a Ti layer and an Au layer on a surface of the compound semiconductor wafer (EPW) in the second embodiment.
FIG. 11 is a view illustrating an example of vapor-depositing a Ti layer and an Au layer on a surface of a to-be-bonded wafer in the second embodiment.
FIG. 12 is a view illustrating an example of the compound semiconductor wafer (EPW) having the Ti and Au layers vapor-deposited on the surface and the to-be-bonded wafer having the Ti and Au layers vapor-deposited on the surface in the second embodiment.
FIG. 13 is a view illustrating an example of bonding the compound semiconductor wafer (EPW) having the Ti and Au layers vapor-deposited on the surface to the to-be-bonded wafer having the Ti and Au layers vapor-deposited on the surface in the second embodiment.
FIG. 14 is a view illustrating the compound semiconductor wafer (EPW) in a circular form and a central point thereof (black circle) in the second embodiment.
FIG. 15 is a view illustrating the to-be-bonded wafer in a circular form and a central point thereof (black circle) in the second embodiment.
FIG. 16 is a view illustrating the compound semiconductor wafer (EPW) in a rectangular form and a central point thereof (black circle) in the second embodiment.
FIG. 17 is a view illustrating an example of removing a growth substrate after the compound semiconductor wafer (EPW) having the Ti and Au layers vapor-deposited on the surface is bonded to the to-be-bonded wafer having the Ti and Au layers vapor-deposited on the surface in the second embodiment.
FIG. 18 is a view illustrating an example of a schematic cross-sectional view of a compound semiconductor wafer (EPW) usable in a method for manufacturing a bonded wafer according to the present invention (third embodiment).
FIG. 19 is a view illustrating an example of the compound semiconductor wafer (EPW) on a surface of which a BCB film is formed and a to-be-bonded wafer in the third embodiment.
FIG. 20 is a view illustrating an example of bonding the compound semiconductor wafer (EPW) having the BCB film formed on the surface to the to-be-bonded wafer in the third embodiment.
FIG. 21 is a view illustrating the compound semiconductor wafer (EPW) in a circular form and a central point thereof (black circle) in the third embodiment.
FIG. 22 is a view illustrating the to-be-bonded wafer in a circular form and a central point thereof (black circle) in the third embodiment.
FIG. 23 is a view illustrating the compound semiconductor wafer (EPW) in a rectangular form and a central point thereof (black circle) in the third embodiment.
FIG. 24 is a view illustrating an example of removing a growth substrate after the compound semiconductor wafer (EPW) having the BCB film formed on the surface is bonded to the to-be-bonded wafer in the third embodiment.
FIG. 25 is a graph illustrating a relation between the number of cracks and the deviation of the center of a compound semiconductor wafer from the center of a to-be-bonded wafer.
FIG. 26 is a graph illustrating a relation between the distance from the center of a compound semiconductor wafer and the height of the wafer (Example 4, Comparative Example).

### DESCRIPTION OF EMBODIMENTS

The present inventors have earnestly studied the above problems and consequently found the following method for manufacturing a bonded wafer by bonding a to-be-bonded wafer and a compound semiconductor wafer including a compound semiconductor epitaxially grown on a growth substrate. The bonding surface area of the to-be-bonded wafer is larger than the bonding surface area of the compound semiconductor wafer. The growth substrate is removed after the to-be-bonded wafer is bonded to the bonding surface of the compound semiconductor wafer, which is the compound semiconductor side, where the epitaxial growth takes place. When a substrate allowing device processing is prepared by bonding a compound semiconductor wafer with small diameter or small size onto a to-be-bonded wafer, this method for manufacturing a bonded wafer enables manufacturing of a bonded wafer whose epitaxial layer has less crack formation. This finding has led to the completion of the present invention.

Moreover, it has been found a bonded wafer including a compound semiconductor wafer and a to-be-bonded wafer bonded thereto and having an area larger than the bonding surface area of the compound semiconductor wafer. The compound semiconductor wafer has a total thickness of 15 µm or less. This bonded wafer is a bonded wafer with satisfactorily suppressed crack formation in the epitaxial layer. This finding has led to the completion of the present invention.

Hereinafter, with reference to the drawings, detailed description will be given for: a bonded wafer according to the present invention, and a method for manufacturing a bonded wafer which can be employed for the inventive bonded wafer. Nevertheless, the present invention is not limited thereto.

### (First Embodiment)

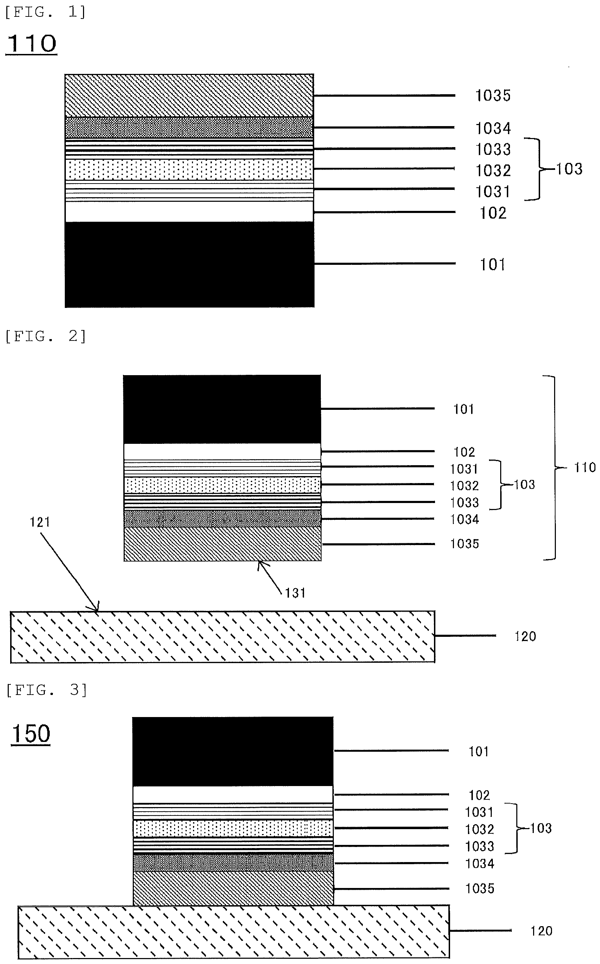

As shown in FIG. 1, a compound semiconductor wafer (EPW) 110 is prepared which includes: a growth substrate (starting substrate) 101, for example, made of GaAs having a thickness of 550 um and a diameter of 6 inches; a light-emitting-diode-functional layer 103 made of AlGaInP; and an etch stop (ES) layer 102 made of InGaP or InAlP or AlGaInP having a thickness of 0.1 um. The light-emitting-diode-functional layer 103 and the etch stop (ES) layer 102 are formed by an MOVPE method, for example. The etch stop (ES) layer 102 is formed between the growth substrate and the light-emitting-diode-functional layer.

The AlGaInP-based light-emitting-diode-functional layer 103 can sequentially include from the starting substrate 101 side: for example, a p-type Al_{1-y}In_{y}P layer 1031 (0.4≤y≤0.5) having a thickness of 1 um and a carrier concentration of approximately 1×10¹⁷/cm³; an (Al₁₋ₓGaₓ)_{1-y}In_{y}P layer (active layer) 1032 (0.45≤x≤1, 0.4≤y≤0.5) having a thickness of 0.6 µm; and an n-type Al_{1-y}In_{y}P layer 1033 (0.4≤y≤0.5) having a thickness of 1 µm and a carrier concentration of approximately 1×10¹⁷/cm³. Note that, here, a basic structure is exemplified, and the thicknesses of the p-type Al_{1-y}In_{y}P layer 1031, the active layer 1032, and the n-type Al_{1-y}In_{y}P layer 1033 are not limited to the exemplified numerical values.

Moreover, the carrier concentrations can be set within a range up to approximately 3×10¹⁸/cm³ depending on the required function. Further, the carrier concentration profiles are not limited to uniform distribution, either. Furthermore, the exemplified carrier concentrations are average carrier concentrations, and it is a matter of course that these concentrations conceptually include partially low carrier concentration state (e.g., approximately 0.7×10¹⁵/cm³).

Additionally, a window layer may be provided as necessary. As the window layer, GaP is suitably selected for the AlGaInP-based light-emitting-diode-functional layer structure. The window layer 1035 made of GaP and having a thickness of approximately 10 um may be stacked. Further, between the window layer 1035 and the light-emitting-diode-functional layer functional layer 103, a reduction layer 1034 made of Ga_{1-y}In_{y}P layer (0<y<1) may be provided to reduce band discontinuity amount.

Meanwhile, although the AlGaInP-based light-emitting-diode-functional layer is exemplified here, any function and structure can be selected, as long as the lattice constant of the material matches that of the GaAs substrate. Besides the AlGaInP-based semiconductor laser, it is also possible to apply InGaP-based hetero bipolar transistor and field-effect transistor, InGaP/GaAs-based solar cell, GaAsP-based photodiode, etc.

Meanwhile, as long as the lattice constant of the material matches that of an InP substrate, it is possible to apply InGaAs-based hetero bipolar transistor and field-effect transistor, InGaAs-based light-emitting device (semiconductor laser and light-emitting diode), InGaAs(P)-based photodiode, etc.

Furthermore, the above applicable functional layers are just examples, and the materials and usage are not particularly limited.

In this event, preferably, the functional layer including a window layer, if provided, has a total thickness of 15 um or less; in other words, the compound semiconductor wafer from which the growth substrate is removed, which will be described later, has a total thickness of 15 um or less. This prevents warp of the wafer from increasing, can suppress crack formation, and can suppress yield reduction due to wafer breakage in bonding. More preferably, designing the total thickness to be 7 µm or less can further suppress crack formation. The lower limit value of the total thickness is not particularly limited, but is preferably 0.5 µm or more.

Next, a to-be-bonded wafer 120 is prepared as shown in FIG. 2. In this event, the to-be-bonded wafer is preferably a wafer having sufficient flatness, for example, silicon, sapphire, or quartz. This can reduce the cost of the to-be-bonded wafer. As the to-be-bonded wafer 120, for example, a silicon wafer having a diameter of 8 inches is usable.

In the present invention, an area of a bonding surface of the to-be-bonded wafer is larger than an area of a bonding surface of the compound semiconductor wafer. Note that, in the first embodiment, a circular wafer is exemplified, but the wafer shape is not particularly limited and may be, for example, rectangular, square, etc.

Next, both of the EPW 110 and the to-be-bonded wafer 120 are subjected to wet surface treatment with an alkaline solvent. For example, the wafers may be immersed in a 5 wt% NaOH aqueous solution for 10 minutes, then rinsed, and dried in air.

In this event, it is preferable to directly bond the compound semiconductor wafer and the to-be-bonded wafer. This can suppress yield reduction due to bonding failure in the bonding.

As shown in FIGs. 2, 3, both of the EPW 110 and the to-be-bonded wafer 120 are introduced into a bonding apparatus such that an epitaxial surface 131 of the EPW 110 and a polished surface 121 of the to-be-bonded wafer 120 face and are superposed on each other. The wafers are bonded at 200°C under vacuum atmosphere to prepare a bonded substrate 150.

In this event, the bonding is preferably performed such that the center of the compound semiconductor wafer and the center of the to-be-bonded wafer are arranged to deviate from each other by 5 mm or less. In this manner, crack formation can be suppressed.

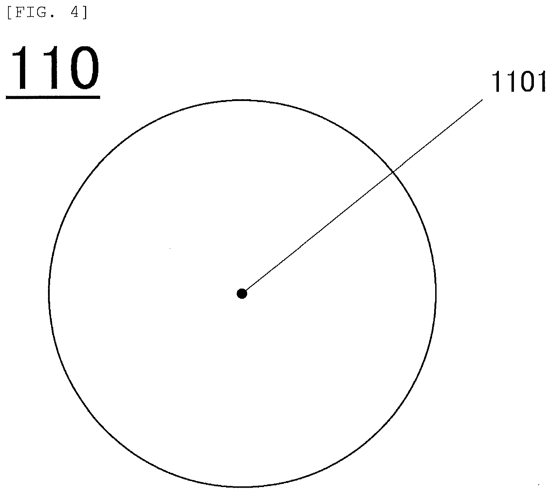

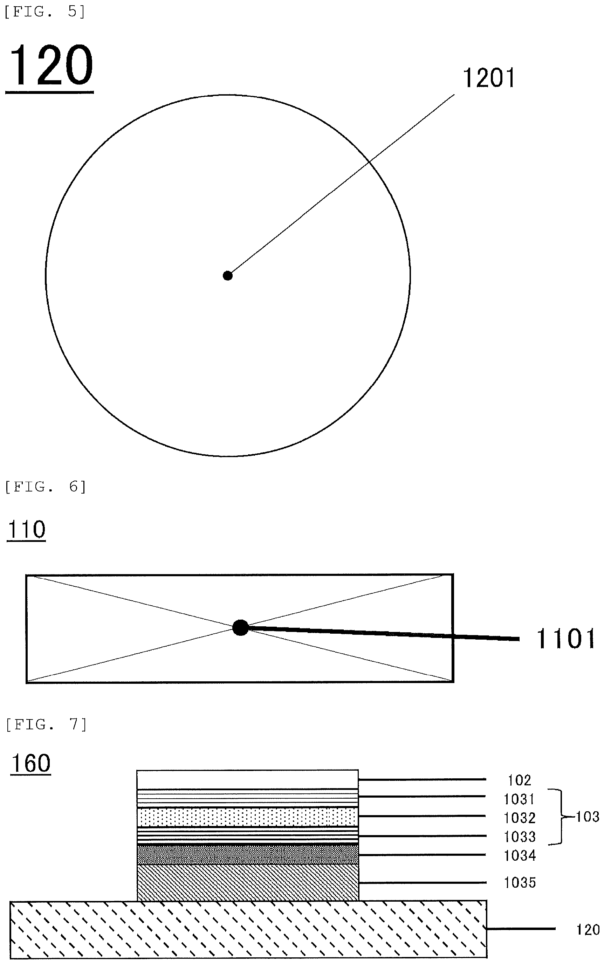

Specifically, in the first embodiment, at the time of the bonding, a central point 1101 of the EPW 110 shown in FIG. 4 is preferably arranged at such a position that the deviation from a central point 1201 of the to-be-bonded wafer 120 shown in FIG. 5 is minimized to 5 mm or less.

In the case of circular wafers, the centers are obvious. In cases of the wafer 110 not in a circular shape but in, for example, a rectangular shape as shown in FIG. 6, the central point 1101 is re-defined as the center of mass. (e.g., in the case of a rectangular shape, the central point 1101 is defined as an intersection where diagonals intersect.)

The to-be-bonded wafer is bonded to a side, where the compound semiconductors are epitaxially grown, as the bonding surface of the compound semiconductor wafer. The pressure during the bonding can be 5 N/cm² or more and 400 N/cm² or less based on the pressure applied to the EPW 110.

The applied pressure thus exemplified is not limited to this range. When the bonding is performed under a condition where the EPW 110 with small diameter withstands the applied pressure (e.g., the substrate thickness is increased), the applied pressure is not limited to the exemplified range. It is a matter of course that a pressure higher than this range is also applicable.

Moreover, the bonding progresses when the alkali-treated surfaces contact. Hence, the bonding is possible even at a pressure lower than the exemplified pressure. For example, such a method as follows is conceivable: a buffer material is placed between the two wafers, and the buffer material is pulled out under vacuum to bring the wafers into contact with each other. In this case, no pressure is applied. At this process stage, the pressure application is not always necessary. Thus, it is possible to select a method in which the two are brought into contact with each other under the disclosed vacuum, too.

Next, the starting substrate 101 is removed from the bonded substrate 150 by wet etching. The wet etching is performed with a liquid mixture of ammonia and hydrogen peroxide water (APM). Since the APM liquid has etching selectivity with respect to the ES layer 102, only GaAs is etched, and the etching is stopped at the ES layer 102. Hence, as shown in FIG. 7, a starting substrate-removed wafer 160 can be obtained from the bonded substrate 150 from which only the GaAs substrate serving as the growth substrate is removed.

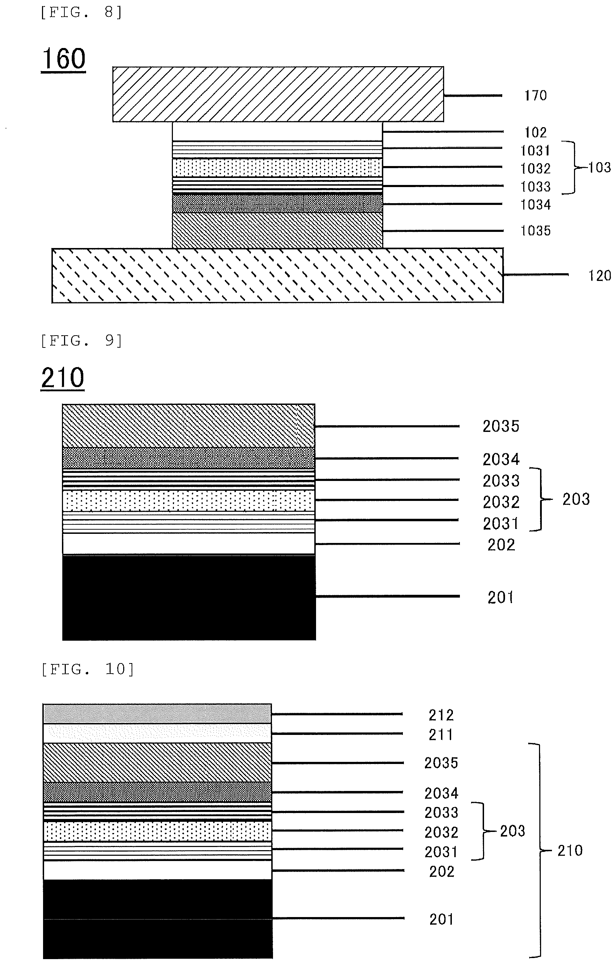

Next, as shown in FIG. 8, the substrate-removed surface is covered with a silicon wafer 170 having a diameter of 6 inches. Here, although a silicon wafer is selected as the cover material, an inexpensive material reliably having flatness is preferable and is not limited to silicon. Moreover, the silicon wafer 170 is not limited to silicon having a diameter of 6 inches, and a wafer having a diameter of 8 inches or more can also be selected in accordance with the diameter of the to-be-bonded member 120. Selecting either wafer makes no difference in result.

The bonded wafer having the cover wafer placed thereon is subjected to compression bonding under vacuum atmosphere and heated at a temperature of 500°C or less. The compression bonding is performed at a pressure of 5 N/cm² or more and 400 N/cm² or less. The heating time can be approximately 5 minutes. The longer the heating time, the higher the strength. In this step, the heating may be performed at a higher temperature than this disclosure, as long as it is possible to keep sufficient strength to prevent delamination of the epitaxial layer in the subsequent heating step.

Next, the silicon wafer 170 is removed and the starting substrate-removed wafer 160 is introduced into a heating furnace. The atmosphere of the heating furnace is selected in accordance with the material of the surface from which the substrate has been removed. Since the InGaP layer is exposed in the first embodiment, the heating is performed under a P atmosphere (1×10⁵ atm). When an InP substrate is used, an As-based material, such as GaAs, is exposed; in this case, the heating is performed under an As atmosphere (1×10⁵ atm). The heating is performed at a temperature of 600 to 800°C. The heating temperature is preferably higher because high strength is obtained within shorter time by higher temperature. To achieve this, high group-V pressure is required. Thus, adjustment may be made appropriately depending on the system to be manufactured, design, etc.

Performing the above steps makes it possible to manufacture a wafer which has high bonding strength, and in which only the thin compound epitaxial functional layer with no cracks exists on the large-diameter silicon substrate.

### (Second Embodiment)

As shown in FIG. 9, a compound semiconductor wafer (EPW) 210 is prepared which includes: a growth substrate (starting substrate) 201, for example, made of GaAs having a thickness of 550 µm and a diameter of 6 inches; a light-emitting-diode-functional layer 203 made of AlGaInP; and an etch stop (ES) layer 202 made of InGaP or InAlP or AlGaInP having a thickness of 0.1 um. The light-emitting-diode-functional layer 203 and the etch stop (ES) layer 202 are formed by an MOVPE method, for example. The etch stop (ES) layer 202 is formed between the starting substrate and the functional layer.

The AlGaInP-based light-emitting-diode-functional layer 203 can sequentially include from the starting substrate 201 side: for example, a p-type Al_{1-y}In_{y}P layer 2031 (0.4≤y≤0.5) having a thickness of 1 um and a carrier concentration of approximately 1×10¹⁷/cm³; an (Al₁₋ₓGaₓ)_{1-y}In_{y}P layer (active layer) 2032 (0.45≤x≤1, 0.4≤y≤0.5) having a thickness of 0.6 um; and an n-type Al_{1-y}In_{y}P layer 2033 (0.4≤y≤0.5) having a thickness of 1 um and a carrier concentration of approximately 1×10¹⁷/cm³. Note that, here, a basic structure is exemplified, and the thicknesses of the p-type Al_{1-y}In_{y}P layer 2031, the active layer 2032, and the n-type Al_{1-y}In_{y}P layer 2033 are not limited to the exemplified numerical values.

Moreover, the carrier concentrations can be set within a range up to approximately 3×10¹⁸/cm³, depending on the required function. Further, the carrier concentration profiles are not limited to uniform distribution, either. Furthermore, the exemplified carrier concentrations are average carrier concentrations, and it is a matter of course that these concentrations conceptually include partially low carrier concentration state (e.g., approximately 0.7×10¹⁵/cm³).

Additionally, a window layer may be provided as necessary. As the window layer, GaP is suitably selected for the AlGaInP-based light-emitting-diode-functional layer structure. The window layer 2035 made of GaP and having a thickness of approximately 10 um may be stacked. Further, between the window layer 2035 and the light-emitting-diode-functional layer 203, a reduction layer 2034 made of Ga_{1-y}In_{y}P layer (0<y<1) may be provided to reduce band discontinuity amount.

Meanwhile, although the AlGaInP-based light-emitting-diode-functional layer is exemplified here, any function and structure can be selected, as long as the lattice constant of the material matches that of the GaAs substrate. Besides the AlGaInP-based semiconductor laser, it is also possible to apply InGaP-based hetero bipolar transistor and field-effect transistor, InGaP/GaAs-based solar cell, GaAsP-based photodiode, etc.

Meanwhile, as long as the lattice constant of the material matches that of an InP substrate, it is possible to apply InGaAs-based hetero bipolar transistor and field-effect transistor, InGaAs-based light-emitting device (semiconductor laser and light-emitting diode), InGaAs(P)-based photodiode, etc.

Furthermore, the above applicable functional layers are just examples, and the materials and usage are not particularly limited.

In this event, preferably, the functional layer including a window layer, if provided, has a total thickness of 15 µm or less; in other words, the compound semiconductor wafer from which the growth substrate is removed, which will be described later, has a total thickness of 15 µm or less. This prevents warp of the wafer from increasing, can suppress crack formation, and can suppress yield reduction due to wafer breakage in bonding. More preferably, designing the total thickness to be 7 um or less can further suppress crack formation. The lower limit value of the total thickness is not particularly limited, but is preferably 0.5 um or more.

Next, a to-be-bonded wafer 220 is prepared. In this event, the to-be-bonded wafer is preferably a wafer having sufficient flatness, for example, silicon, sapphire, or quartz. These can reduce the cost of the to-be-bonded wafer. As the to-be-bonded wafer 220, a silicon wafer having a diameter of 8 inches is usable.

In the present invention, an area of a bonding surface of the to-be-bonded wafer is larger than an area of a bonding surface of the compound semiconductor wafer. Note that, in the second embodiment, a circular wafer is exemplified, but the wafer shape is not particularly limited and may be, for example, rectangular, square, etc.

In this event, the to-be-bonded wafer and the compound semiconductor wafer are preferably bonded by metal bonding with a metal. In this way, the bonding can be performed relatively easily, and the bonded resultant can be directly used as a final device element.

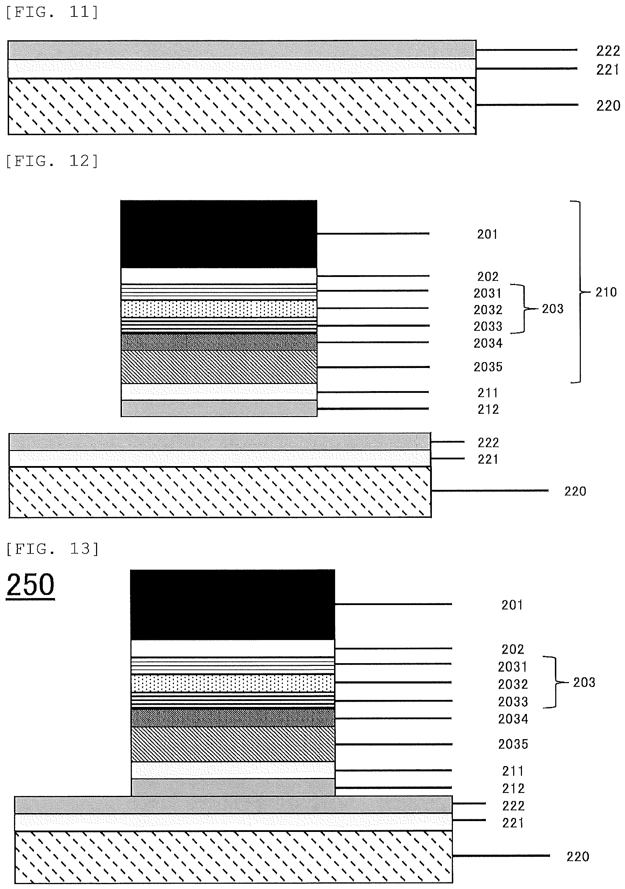

As shown in FIGs. 10 and 11, metal films are vapor-deposited on both of the EPW 210 and the to-be-bonded wafer 220. On the EPW 210, for example, a 0.1-µm Ti layer 211 and a 1-pm Au layer 212 can be provided as vapor-deposited films. On the silicon wafer, for example, a 0.1-pm Ti layer 221 and a 1-µm Au layer 222 can be provided as vapor-deposited films. Here, although these structures and film thicknesses are exemplified, it is a matter of course that any material can be selected if required for the bonding.

In this event, the metal in the metal bonding preferably includes at least one or more of Au, Ag, Al, In, and Ga. These can suppress yield reduction due to bonding failure in the bonding.

To reduce bonding failure in the bonding to increase the yield, the material of the uppermost layer (Au in the exemplified embodiment) desirably contains at least one or more of Au, Ag, Al, In, and Ga, and the film thickness is desirably 0.3 um or more. Moreover, in terms of bonding yield, the film thickness may be large without limitation. However, the large thickness brings similar effect in terms of yield. The upper limit of the film thickness is determined from economical viewpoint. From economical viewpoint, 3 µm or less is desirable.

Next, as shown in FIGs. 12 and 13, both of the EPW 210 and the to-be-bonded wafer 220 are introduced into a bonding apparatus such that the Au layer 212 of the EPW and the Au layer 222 of the to-be-bonded wafer face and are superposed on each other. The wafers are bonded to prepare a bonded substrate 250.

In this event, the bonding is preferably performed such that the center of the compound semiconductor wafer and the center of the to-be-bonded wafer are arranged to deviate from each other by 5 mm or less. In this manner, crack formation can be further suppressed.

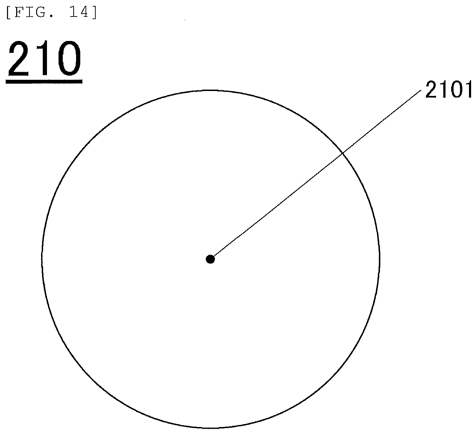

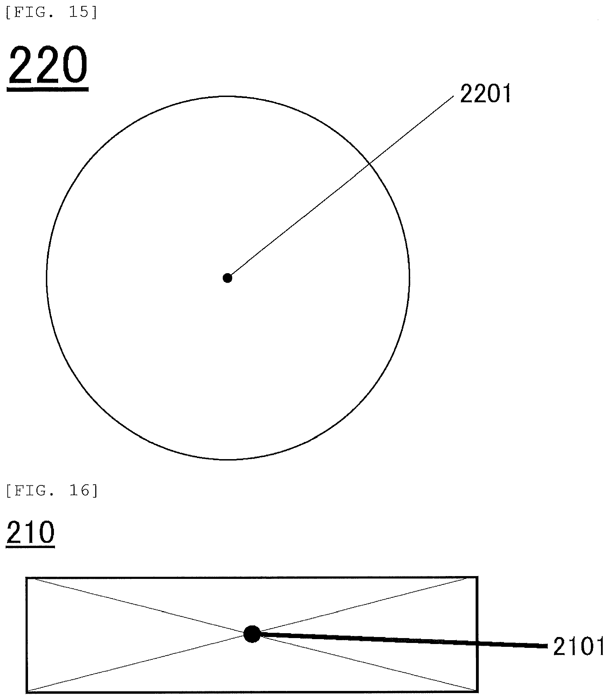

Specifically, in the second embodiment, at the time of the bonding, a central point 2101 of the EPW 210 shown in FIG. 14 is preferably arranged at such a position that the deviation from a central point 2201 of the to-be-bonded wafer 220 shown in FIG. 15 is minimized to 5 mm or less.

In the case of circular wafers, the centers are obvious. In cases of the wafer 210 not in a circular shape but in, for example, a rectangular shape as shown in FIG. 16, the central point 2101 is re-defined as the center of mass. (e.g., in the case of a rectangular shape, the central point 2101 is defined as an intersection where diagonals intersect.)

The to-be-bonded wafer is bonded to a side, where the compound semiconductors are epitaxially grown, as the bonding surface of the compound semiconductor wafer. The pressure during the bonding can be 5 N/cm² or more and 400 N/cm² or less based on the pressure applied to the compound EPW with small diameter. Simultaneously, a heat at a temperature of 400°C or less can also be applied. The applied pressure thus exemplified is not limited to this range. When the bonding is performed under a condition where the EPW 210 with small diameter withstands the applied pressure (e.g., the substrate thickness is increased), the applied pressure is not limited to the exemplified range, and a pressure higher than this range is also applicable. In addition, the pressure application and heating are simultaneously performed here. Alternatively, the pressure application and the heat treatment may be performed separately such that the application is performed solely, followed by heating, for example.

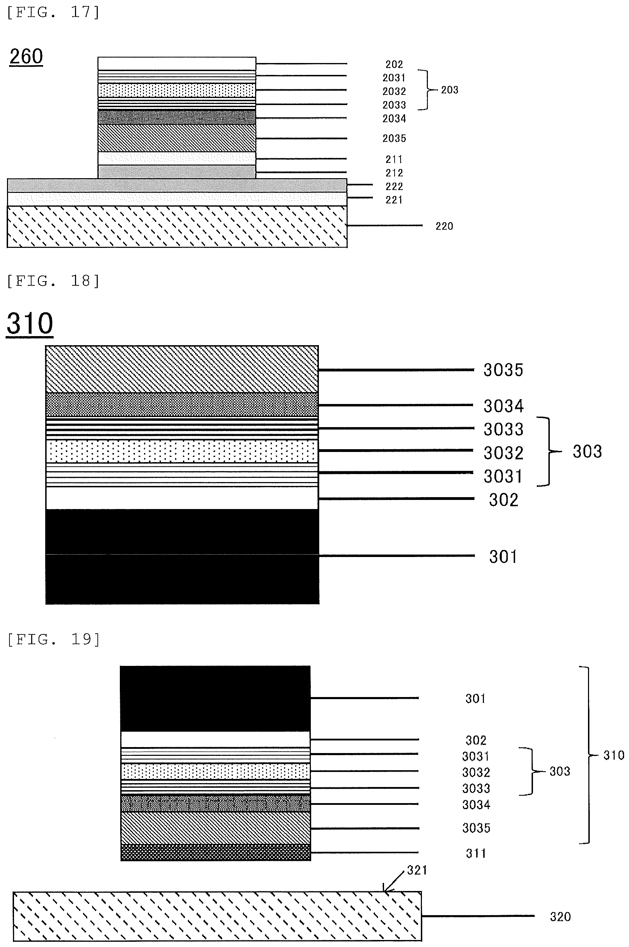

Next, the starting substrate 201 is removed from the bonded substrate 250 shown in FIG. 13 by wet etching. The wet etching is performed with a liquid mixture of ammonia and hydrogen peroxide water (APM). Since the APM liquid has etching selectivity with respect to the ES layer 202, only GaAs is etched, and the etching is stopped at the ES layer 202. Hence, as shown in FIG. 17, a starting substrate-removed wafer 260 can be obtained from the bonded substrate 250 from which only the GaAs substrate serving as the growth substrate is removed.

Although exemplified here is an example where the heat treatment is performed before the substrate is removed, similar effects are also obtained even when the heat treatment is performed after the substrate removal.

Performing the above steps makes it possible to manufacture a wafer which has high bonding strength, and in which only the thin compound epitaxial functional layer with no cracks exists on the large-diameter silicon substrate.

### (Third Embodiment)

As shown in FIG. 18, a compound semiconductor epitaxial wafer (EPW) 310 is prepared which includes: a growth substrate (starting substrate) 301, for example, made of GaAs having a thickness of 550 um and a diameter of 6 inches; a light-emitting-diode-functional layer 303 made of AlGaInP; and an etch stop (ES) layer 302 made of InGaP or InAlP or AlGaInP having a thickness of 0.1 µm between the starting substrate and the functional layer.

The AlGaInP-based light-emitting-diode-functional layer 303 can sequentially include from the starting substrate 301 side: for example, a p-type Al_{1-y}In_{y}P layer 3031 (0.4≤y≤0.5) having a thickness of 1 um and a carrier concentration of approximately 1×10¹⁷/cm³; an (Al₁₋ₓGaₓ)_{1-y}In_{y}P layer (active layer) 3032 (0.45≤x≤1, 0.4≤y≤0.5) having a thickness of 0.6 µm; and an n-type Al_{1-y}In_{y}P layer 3033 (0.4≤y≤0.5) having a thickness of 1 um and a carrier concentration of approximately 1×10¹⁷/cm³. Note that, here, a basic structure is exemplified, and the thicknesses of the p-type layer 3031, the active layer 3032, and the n-type layer 3033 are not limited to the exemplified numerical values.

Moreover, the carrier concentrations can be set within a range up to approximately 3×10¹⁸/cm³ depending on the required function. Further, the carrier concentration profiles are not limited to uniform distribution, either. Furthermore, the exemplified carrier concentrations are average carrier concentrations, and it is a matter of course that these concentrations conceptually include partially low carrier concentration state (e.g., approximately 0.7×10¹⁵/cm³).

Additionally, a window layer may be provided as necessary. As the window layer, GaP is suitably selected for the AlGaInP-based light-emitting-diode-functional layer structure. The window layer 3035 made of GaP and having a thickness of 10 µm is stacked. Further, between the window layer 3035 and the light-emitting-diode-functional layer 303, a reduction layer 3034 made of Ga_{1-y}In_{y}P layer (0<y<1) may be provided to reduce band discontinuity amount.

Meanwhile, although the AlGaInP-based light-emitting-diode-functional layer is exemplified here, any function and structure can be selected, as long as the lattice constant of the material matches that of the GaAs substrate. Besides the AlGaInP-based semiconductor laser, it is also possible to apply InGaP-based hetero bipolar transistor and field-effect transistor, InGaP/GaAs-based solar cell, GaAsP-based photodiode, etc.

Meanwhile, as long as the lattice constant of the material matches that of an InP substrate, it is possible to apply InGaAs-based hetero bipolar transistor and field-effect transistor, InGaAs-based light-emitting device (semiconductor laser and light-emitting diode), InGaAs(P)-based photodiode, etc.

Furthermore, the above applicable functional layers are just examples, and the materials and usage are not limited.

In this event, preferably, the functional layer including a window layer, if provided, has a total thickness of 15 µm or less; in other words, the compound semiconductor wafer from which the growth substrate is removed, which will be described later, has a total thickness of 15 µm or less. This prevents warp of the wafer from increasing, can suppress crack formation, and can suppress yield reduction due to wafer breakage in bonding. More preferably, designing the total thickness to be 7 µm or less can further suppress crack formation. The lower limit value of the total thickness is not particularly limited, but is preferably 0.5 µm or more.

Next, a to-be-bonded wafer 320 is prepared as shown in FIG. 19. In this event, the to-be-bonded wafer is preferably a wafer having sufficient flatness, for example, silicon, sapphire, or quartz. This can reduce the cost of the to-be-bonded wafer. As the to-be-bonded wafer 320, for example, a silicon wafer having a diameter of 8 inches is usable.

In the present invention, an area of a bonding surface of the to-be-bonded wafer is larger than an area of a bonding surface of the compound semiconductor wafer. Note that, in the third embodiment, a circular wafer is exemplified, but the wafer shape is not particularly limited and may be, for example, rectangular, square, etc.

In this event, the to-be-bonded wafer and the compound semiconductor wafer are preferably bonded by bonding with a resin or polymer interposed therebetween. In this way, the bonding can be performed relatively easily, and the bonded resultant can be directly used as a final device element.

Moreover, in this event, the resin or polymer is preferably benzocyclobutene, polyimide, or glass with TEOS. In these ways, yield reduction due to bonding failure in the bonding can be further suppressed.

The EPW 310 is spin-coated with benzocyclobutene (BCB). The viscosity and the number of spinnings are adjusted to form a BCB film 311 having a thickness of approximately 3 µm, for example. Here, exemplified is a case of forming the BCB film 311 on only the EPW 310. Nevertheless, the BCB film 311 may be formed on both of the EPW 310 and the to-be-bonded wafer 320, or may be formed on only the to-be-bonded wafer 320. In these cases, similar effects are obtained.

Moreover, although exemplified here is the case where the BCB thickness is 3 µm, the film thickness can be changed within approximately 0.5 to 20 um by adjusting the viscosity. Nevertheless, since increasing the BCB film thickness increases the thermal resistance, the BCB thickness is preferably approximately 0.5 to 20 µm at most. Further, forming a thick BCB film causes cost increase. From these viewpoints, the film thickness is appropriately 12 µm or less, but may exceed this range.

Further, although spin-coating with BCB is exemplified here, spin-coating with polyimide (PI) instead of BCB may be performed. Meanwhile, similar effects are obtained by spin-coating with TEOS after a porous silicon film or another porous film is formed on the EPW 310, or on the to-be-bonded wafer 320, or on both of the EPW 310 and the to-be-bonded wafer 320.

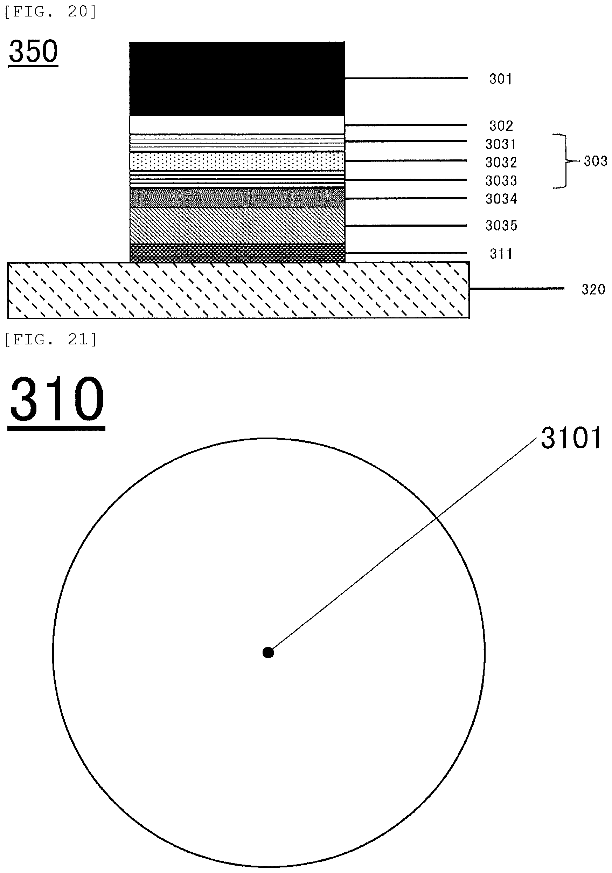

Next, as shown in FIGs. 19 and 20, both of the EPW 310 and the to-be-bonded wafer 320 are introduced into a bonding apparatus such that the BCB layer 311 of the EPW and a surface 321 of the to-be-bonded wafer face and are superposed on each other. The wafers are bonded to prepare a bonded substrate 350.

In this event, the bonding is preferably performed such that the center of the compound semiconductor wafer and the center of the to-be-bonded wafer are arranged to deviate from each other by 5 mm or less. In this manner, crack formation can be suppressed.

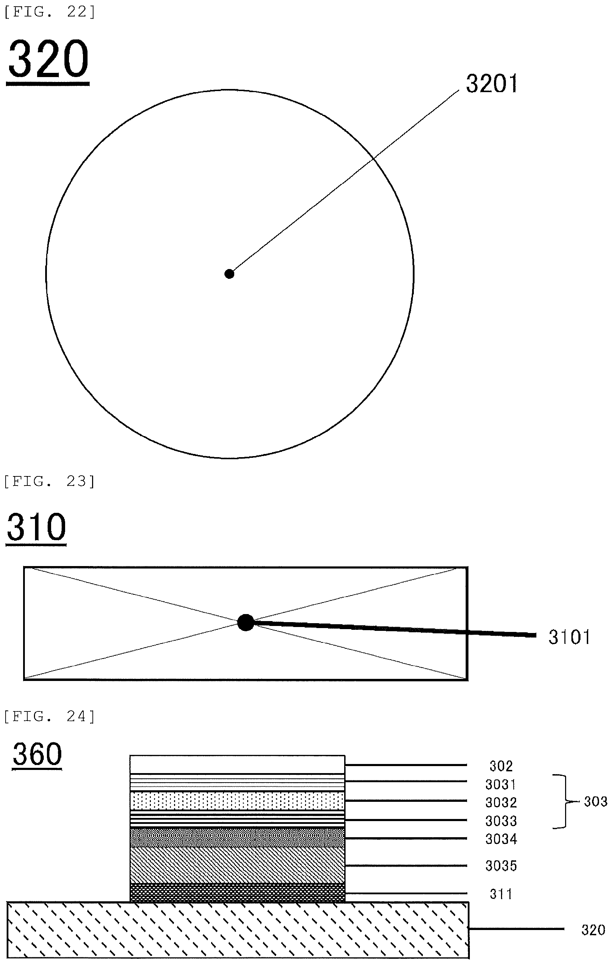

Specifically, in the third embodiment, at the time of the bonding, a central point 3101 of the EPW 310 shown in FIG. 21 is preferably arranged at such a position that the deviation from a central point 3201 of the to-be-bonded wafer 320 shown in FIG. 22 is minimized to 5 mm or less.

In the case of circular wafers, the centers are obvious. In cases of the wafer 310 not in a circular shape but in, for example, a rectangular shape as shown in FIG. 23, the central point 3101 is re-defined as the center of mass. (e.g., in the case of a rectangular shape, the central point 3101 is defined as an intersection where diagonals intersect.)

The to-be-bonded wafer is bonded to a side, where the compound semiconductors are epitaxially grown, as the bonding surface of the compound semiconductor wafer. The pressure during the bonding can be 5 N/cm² or more and 400 N/cm² or less based on the pressure applied to the compound EPW with small diameter. The applied pressure thus exemplified is not limited to this range. When the bonding is performed under a condition where the EPW 310 with small diameter withstands the applied pressure (e.g., the substrate thickness is increased), is not limited to the exemplified range, a pressure higher than this range is also applicable. In addition, the pressure application and heating may be performed simultaneously here. Similar effects are obtained even when the pressure application and the heat treatment are performed separately such that the application is performed solely, followed by heating, for example.

Next, the starting substrate 301 is removed from the bonded substrate 350 by wet etching. The wet etching is performed with a liquid mixture of ammonia and hydrogen peroxide water (APM). Since the APM liquid has etching selectivity with respect to the ES layer 302, only GaAs is etched, and the etching is stopped at the ES layer 302. Hence, as shown in FIG. 24, a starting substrate-removed wafer 360 can be obtained from the bonded substrate 350 from which only the GaAs substrate serving as the growth substrate is removed.

Although exemplified here is an example where no heat treatment is performed after the substrate removal, it is needless to say that similar effects are also obtained even when the heat treatment is performed after the substrate removal.

Performing the above steps makes it possible to manufacture a wafer which has high bonding strength, and in which only the thin compound epitaxial functional layer with no cracks exists on the large-diameter silicon substrate.

### EXAMPLE

Hereinafter, the present invention will be described in detail with reference to Examples. However, the present invention is not limited thereto.

### (Example 1)

The epitaxial wafers (EPWs) 110 were prepared each of which included: the growth substrate (starting substrate) 101 made of GaAs having a thickness of 550 um and a diameter of 6 inches (150 mm); the AlGaInP-based light-emitting-diode-functional layer 103; and the etch stop (ES) layer 102 made of InGaP having a thickness of 0.1 um and located between the starting substrate and the light-emitting-diode-functional layer.

The AlGaInP-based light-emitting-diode-functional layer 103 sequentially included from the starting substrate 101 side: the p-type Al_{1-y}In_{y}P layer 1031 (0.4≤y≤0.5) having a thickness of 1 µm and a carrier concentration of approximately 1×10¹⁷/cm³; the (Al₁₋ₓGaₓ)_{1-y}In_{y}P layer (active layer) 1032 (0.45≤x≤1, 0.4≤y≤0.5) having a thickness of 0.6 um; and the n-type Al_{1-y}In_{y}P layer 1033 (0.4≤y≤0.5) having a thickness of 1 µm and a carrier concentration of approximately 1×10¹⁷/cm³.

Moreover, the window layer 1035 made of GaP having a thickness of 10 um was stacked. Further, between the window layer 1035 and the functional layer 103, the reduction layer 1034 made of Ga_{1-y}In_{y}P layer (0<y<1) was provided to reduce band discontinuity amount.

As the to-be-bonded wafers 120, silicon wafers having a diameter of 8 inches (200 mm) were used.

Next, wet surface treatment with an alkaline solvent was performed on all of the EPWs 110 and the to-be-bonded wafers 120. In this Example, the wafers were immersed in a 5 wt% NaOH aqueous solution for 10 minutes, then rinsed, and dried in air.

Each pair of the EPW 110 and the to-be-bonded wafer 120 were introduced into a bonding apparatus such that the epitaxial surface 131 of the EPW 110 and the polished surface 121 of the to-be-bonded wafer 120 faced and were superposed on each other. The wafers were bonded at 200°C under vacuum atmosphere to prepare the bonded substrate 150.

In the bonding, the paired wafers were bonded such that the deviation of the central point 1101 of the EPW 110 from the central point 1201 of the to-be-bonded wafer 120 was altered from 1 to 9 mm by 1 mm among the pairs. Moreover, the pressure during the bonding was 50 N/cm². These are shown in Table 1.

**[Table 1]**

| | Example 1 | Example 2 | Example 3 |
|---|---|---|---|
| Growth substrate | GaAs | GaAs | GaAs |
| Thickness [µm] of growth substrate | 550 | 550 | 550 |
| Diameter [inch] of growth substrate | 6 | 6 | 6 |
| Etch stop layer | InGaP | InGaP | InGaP |
| Thickness [um] of etch stop layer | 0.1 | 0.1 | 0.1 |
| Functional layer | AlGaInP-based | AlGaInP-based | AlGaInP-based |
| Thickness [um] of p-type Al_{1-y}In_{y}P layer | 1 | 1 | 1 |
| Thickness [µm] of active layer | 0.6 | 0.6 | 0.6 |
| Thickness [um] of n-type Al_{1-y}In_{y}P layer | 1 | 1 | 1 |
| Window layer | GaP | GaP | GaP |
| Thickness [µm] of window layer | 10 | 10 | 10 |
| Reduction layer | Ga_{1-y}In_{y}P | Ga_{1-y}In_{y}P | Ga_{1-y}In_{y}P |
| To-be-bonded wafer | silicon | silicon | silicon |
| Diameter [inch] of to-be-bonded wafer | 8 | 8 | 8 |
| Bonding method | direct bonding | metal bonding | resin or polymer |
| Bonding material | | Au | BCB |
| Thickness [µm] of bonding material | | EPW: 1 | 3 |
| | | silicon: 1 | |
| Bonding temperature [°C] | 200 | 350 | 350 |
| Bonding atmosphere | vacuum | | |
| Bonding pressure [N/cm²] | 50 | 50 | 50 |
| Growth substrate removal | wet etching | wet etching | wet etching |
| Etching liquid | liquid mixture | liquid mixture | liquid mixture |

Next, the starting substrate 101 was removed from the bonded substrate 150 by wet etching. The wet etching was performed with a liquid mixture of ammonia and hydrogen peroxide water (APM). Since the APM liquid has etching selectivity with respect to the ES layer 102, only GaAs is etched, and the etching is stopped at the ES layer 102. Thus, only the GaAs substrate serving as the growth substrate was removed from the bonded substrate 150, and the starting substrate-removed wafer 160 was obtained.

Next, the surface from which the starting substrate was removed was covered with the silicon wafer 170 having a diameter of 6 inches. The bonded wafer having the cover wafer placed thereon was subjected to compression bonding under vacuum atmosphere and heated at a temperature of 200°C. The pressure was 50 N/cm². The heating time was 5 minutes in this Example.

The silicon wafer 170 was removed, and the starting substrate-removed wafer 160 was introduced into a heating furnace. In Example 1, the InGaP layer was exposed. Hence, the heating was performed under a P atmosphere (1×10⁵ atm). The heating was performed at a temperature of 700°C for approximately 30 minutes.

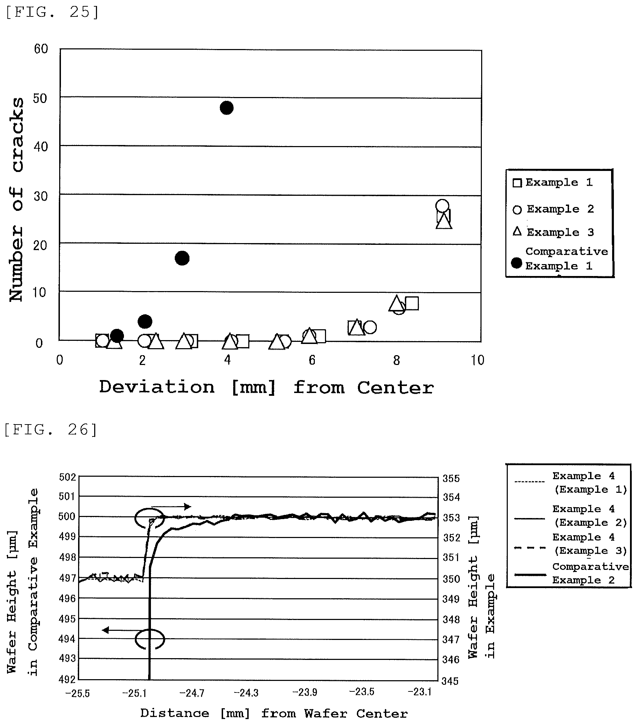

FIG. 25 shows the number of cracks in relation to the deviation of the central point 1101 of the EPW 110 from the central point 1201 of the to-be-bonded wafer 120 in the bonded wafers prepared as above.

### (Example 2)

The epitaxial wafers (EPWs) 210 were prepared each of which included: the growth substrate (starting substrate) 201 made of GaAs having a thickness of 550 µm and a diameter of 6 inches; the AlGaInP-based light-emitting-diode-functional layer 203; and the etch stop (ES) layer 202 made of InGaP having a thickness of 0.1 µm and located between the starting substrate and the light-emitting-diode-functional layer.

The AlGaInP-based light-emitting-diode-functional layer 203 sequentially included from the starting substrate 201 side: the p-type Al_{1-y}In_{y}P layer 2031 (0.4≤y≤0.5) having a thickness of 1 µm and a carrier concentration of approximately 1×10¹⁷/cm³; the (Al₁₋ₓGaₓ)_{1-y}In_{y}P layer (active layer) 2032 (0.45≤x≤1, 0.4≤y≤0.5) having a thickness of 0.6 µm; and the n-type Al_{1-y}In_{y}P layer 2033 (0.4≤y≤0.5) having a thickness of 1 um and a carrier concentration of approximately 1×10¹⁷/cm³.

Moreover, the window layer 2035 made of GaP having a thickness of 10 µm was stacked. Further, between the window layer 2035 and the functional layer 203, the reduction layer 2034 made of Ga_{1-y}In_{y}P layer (0<y<1) was provided to reduce band discontinuity amount.

As the to-be-bonded wafers 220, silicon wafers having a diameter of 8 inches were used.

Next, metal films were vapor-deposited on each EPW 210 and to-be-bonded wafer 220. On the EPW 210, the 0.1-µm Ti layer 211 and the 1-pm Au layer 212 were provided as vapor-deposited films. On the silicon wafer, the 0.1-pm Ti layer 221 and the I-µm Au layer 222 were provided as vapor-deposited films.

Each pair of the EPW 210 and the to-be-bonded wafer 220 were introduced into a bonding apparatus such that the Au layer 212 of the EPW and the Au layer 222 of the to-be-bonded wafer faced and were superposed on each other. The wafers were bonded to prepare the bonded substrate 250.

In the bonding, the paired wafers were bonded such that the deviation of the central point 2101 of the EPW 210 from the central point 2201 of the to-be-bonded wafer 220 was altered from 1 to 9 mm by 1 mm among the pairs. The pressure during the bonding was 50 N/cm². Simultaneously, heating was also performed at 350°C. These are also shown in Table 1.

The starting substrate 201 was removed from the bonded substrate 250 by wet etching. The wet etching was performed with a liquid mixture of ammonia and hydrogen peroxide water (APM).

FIG. 25 also shows the number of cracks in relation to the deviation of the central point 2101 of the EPW 210 from the central point 2201 of the to-be-bonded wafer 220 in the bonded wafers prepared as above.

### (Example 3)

The epitaxial wafers (EPWs) 310 were prepared each of which included: the growth substrate (starting substrate) 301 made of GaAs having a thickness of 550 µm and a diameter of 6 inches; the AlGaInP-based light-emitting-diode-functional layer 303; and the etch stop (ES) layer 302 made of InGaP having a thickness of 0.1 µm and located between the starting substrate and the light-emitting-diode-functional layer.

The AlGaInP-based light-emitting-diode-functional layer 303 sequentially included from the starting substrate 301 side: the p-type Al_{1-y}In_{y}P layer 3031 (0.4≤y≤0.5) having a thickness of 1 µm and a carrier concentration of approximately 1×10¹⁷/cm³; the (Al₁₋ₓGaₓ)_{1-y}In_{y}P layer (active layer) 3032 (0.45≤x≤1, 0.4≤y≤0.5) having a thickness of 0.6 µm; and the n-type Al_{1-y}In_{y}P layer 3033 (0.4≤y≤0.5) having a thickness of 1 µm and a carrier concentration of approximately 1×10¹⁷/cm³.

Moreover, the window layer 3035 made of GaP having a thickness of 10 µm was stacked. Further, between the window layer 3035 and the functional layer 303, the reduction layer 3034 made of Ga_{1-y}In_{y}P layer (0<y<1) was provided to reduce band discontinuity amount.

As the to-be-bonded wafers 320, silicon wafers having a diameter of 8 inches were used.

Next, the EPWs 310 were each spin-coated with benzocyclobutene (BCB). The viscosity and the number of spinnings were adjusted to form the BCB film 311 having a thickness of approximately 3 µm. Then, each pair of the EPW 310 and the to-be-bonded wafer 320 were introduced into a bonding apparatus such that the BCB layer 311 of the EPW and the surface 321 of the to-be-bonded wafer faced and were superposed on each other. The wafers were bonded to prepare the bonded substrate 350.

In the bonding, the paired wafers were bonded such that the deviation of the central point 3101 of the EPW 310 from the central point 3201 of the to-be-bonded wafer 320 was altered from 1 to 9 mm by 1 mm among the pairs. The pressure during the bonding was 50 N/cm². Simultaneously, heating was also performed at 350°C. These are also shown in Table 1.

The starting substrate 301 was removed from the bonded substrate 350 by wet etching. The wet etching was performed with a liquid mixture of ammonia and hydrogen peroxide water (APM).

FIG. 25 also shows the number of cracks in relation to the deviation of the central point 3101 of the EPW 310 from the central point 3201 of the to-be-bonded wafer 320 in the bonded wafers prepared as above.

### (Example 4)

The same procedures as in Examples 1 to 3 were carried out, except that the compound wafers having a diameter of 2 inches (50 mm) were formed on the silicon wafers having a diameter of 4 inches (100 mm), and that the window layer made of GaP and the reduction layer made of GaInP were not formed. FIG. 26 shows a relation between the distance from the center to an edge portion of each compound semiconductor wafer and the wafer height in bonded wafers prepared as described above. Note that, in the horizontal axis of FIG. 26, 0 mm represents the center of the compound semiconductor wafer in the bonded wafer, and -25.4 mm (-1 inch) represents the outermost peripheral portion.

### (Comparative Example 1)

Epitaxial wafers (EPWs) were prepared each of which included: a growth substrate (starting substrate) made of GaAs having a thickness of 550 um and a diameter of 6 inches; an AlGaInP-based light-emitting-diode-functional layer; and an etch stop (ES) layer made of InGaP having a thickness of 0.1 µm and located between the starting substrate and the functional layer.

The AlGaInP-based light-emitting-diode-functional layer sequentially included from the starting substrate side: a p-type Al_{1-y}In_{y}P layer (0.4≤y≤0.5) having a thickness of 1 µm and a carrier concentration of approximately 1×10¹⁷/cm³; an (Al₁₋ₓGaₓ)_{1-y}In_{y}P layer (active layer) (0.45≤x≤1, 0.4≤y≤0.5) having a thickness of 0.6 µm; and an n-type Al_{1-y}In_{y}P layer (0.4≤y≤0.5) having a thickness of 1 µm and a carrier concentration of approximately 1×10¹⁷/cm³.

Next, a window layer made of GaP having a thickness of 10 um was stacked. Further, between the window layer and the functional layer, a reduction layer made of Ga_{1-y}In_{y}P layer (0<y<1) was provided to reduce band discontinuity amount.

After the EPW formation, the back surface side of each starting substrate was lapped and then polished to form a polished surface with a thickness of 150 µm.

As to-be-bonded wafers, silicon wafers having a diameter of 8 inches were used.

Wet surface treatment with an alkaline solvent was performed on all of the EPWs and the to-be-bonded wafers. The wafers were immersed in a 5 wt% NaOH aqueous solution for 10 minutes, then rinsed, and dried in air.

Each pair of the EPW and the to-be-bonded wafer were introduced into a bonding apparatus such that the polished surface of the starting substrate of the EPW and a polished surface of the to-be-bonded wafer faced and were superposed on each other. The wafers were bonded at 350°C under vacuum atmosphere to prepare a bonded substrate.

In the bonding, the paired wafers were bonded such that the deviation of the central point of the EPW from the central point of the to-be-bonded wafer was altered from 1 to 4 mm by 1 mm among the pairs. The pressure during the bonding was such that the pressure of 50 N/cm² was applied to the EPW.

The starting substrate-removed wafer was introduced into a heating furnace. The atmosphere of the heating furnace was selected in accordance with the material of the surface from which the substrate was removed. Since the starting substrate was exposed in Comparative Example 1, the heating was performed under an As atmosphere (1×10⁵ atm) at 700°C for approximately 30 minutes.

FIG. 25 also shows the number of cracks in relation to the deviation of the central point of the epitaxial layer from the central point of the to-be-bonded wafer in the bonded wafers prepared as above.

### (Comparative Example 2)

The same procedure as in Comparative Example 1 was carried out, except that the compound wafers having a diameter of 2 inches were formed on the silicon wafers having a diameter of 4 inches.

As shown in FIG. 25, the bonded wafers were found to have such a trend that the larger the degree of the deviation of the epitaxial layer from the center position, the larger the number of cracks formed in the epitaxial layer.

However, concerning the epitaxial layers in the bonded wafers of Examples 1 to 3 employing the inventive method for manufacturing a bonded wafer, the increase in the number of cracks formed in the epitaxial layers was successfully suppressed in the range where the deviation from the center position was 1 to 5 mm.

Meanwhile, as shown from Comparative Example 2, to form a small-diameter wafer made of a compound semiconductor on a large-diameter silicon wafer so as to achieve permanent bonding, the starting substrate side of the small-diameter wafer has to be flat at such a level as to enable bonding at the atomic level. In addition, since the growth raw materials during the epitaxial growth come to spread over the starting substrate side, these need to be removed. Hence, polishing is required after lapping.

Nevertheless, since compound wafers are brittle materials, the polishing speed at the wafer peripheral portion is fast. Consequently, the film thickness at the peripheral portion was decreased. In the area of approximately 1 mm from the wafer peripheral portion, the film thickness was especially decreased. Although wafer bonding is possible in this state, the wafer will have a height variation between the peripheral portion and the inner side, and the yield is lowered due to the difference in focal depth during the photolithography process. Since the film thickness variation is in micron order, the height greatly varies only in Comparative Example 2, so that the focal depth cannot be kept at a fixed level. Consequently, in the area of approximately 1 mm from the peripheral portion, the pattern size varies, and the yield is considerably lowered.

In contrast, in Example 4 employing the inventive method for manufacturing a bonded wafer, the large height variation (i.e., film thickness variation) at the peripheral portion as in Comparative Example hardly occurred in any case. It was found that in Examples, omitting polishing step after the epitaxial growth essentially contributed to this result. Thus, Example 4 did not have the problems as described above, and the yield will be stable.

It should be noted that the present invention is not limited to the above-described embodiments. The embodiments are just examples, and any embodiments that substantially have the same feature and demonstrate the same functions and effects as those in the technical concept disclosed in claims of the present invention are included in the technical scope of the present invention.

## Claims

1. A method for manufacturing a bonded wafer, the method comprising bonding a to-be-bonded wafer and a compound semiconductor wafer that includes a compound semiconductor epitaxially grown on a growth substrate, wherein
an area of a bonding surface of the to-be-bonded wafer is larger than an area of a bonding surface of the compound semiconductor wafer, and
the growth substrate is removed after the to-be-bonded wafer is bonded to a side, where the compound semiconductor is epitaxially grown, as the bonding surface of the compound semiconductor wafer.

2. The method for manufacturing a bonded wafer according to claim 1, wherein the bonding of the to-be-bonded wafer and the compound semiconductor wafer is performed by any method of direct bonding with no interposition therebetween, metal bonding with a metal, and bonding with a resin or polymer interposed therebetween.

3. The method for manufacturing a bonded wafer according to claim 2, wherein the metal comprises one or more of Au, Ag, Al, In, and Ga.

4. The method for manufacturing a bonded wafer according to claim 2, wherein the resin or polymer comprises benzocyclobutene, polyimide, or glass with TEOS.

5. The method for manufacturing a bonded wafer according to any one of claims 1 to 4, wherein the bonding is performed such that a center of the compound semiconductor wafer and a center of the to-be-bonded wafer are arranged to deviate from each other by 5 mm or less.

6. The method for manufacturing a bonded wafer according to any one of claims 1 to 5, wherein the compound semiconductor wafer from which the growth substrate has been removed has a total thickness of 15 µm or less.

7. The method for manufacturing a bonded wafer according to any one of claims 1 to 6, wherein the to-be-bonded wafer comprises silicon, sapphire, or quartz.

8. A bonded wafer comprising:
a compound semiconductor wafer; and
a to-be-bonded wafer bonded thereto and having an area larger than an area of a bonding surface of the compound semiconductor wafer, wherein
the compound semiconductor wafer has a total thickness of 15 µm or less.
